(19) **Europäisches Patentamt**
**European Patent Office**
**Office européen des brevets**

(11) **EP 2 060 927 B1**

(12) **EUROPÄISCHE PATENTSCHRIFT**

(45) Veröffentlichungstag und Bekanntmachung des Hinweises auf die Patenterteilung:
**11.01.2017 Patentblatt 2017/02**

(51) Int Cl.:
*G01R 33/385* *(2006.01)*    *G01R 33/48* *(2006.01)*

(21) Anmeldenummer: **08019795.7**

(22) Anmeldetag: **13.11.2008**

(54) **NMR-Tomographieverfahren mit 2D-Ortskodierung durch zwei Multipol-Gradientenfelder**

NMR tomography method with 2D spatial encoding using two multipole gradient fields

Procédé de tomographie RMN comprenant un encodage spatial 2D utilisant deux champs de gradient multipolaires

(84) Benannte Vertragsstaaten:
**AT BE BG CH CY CZ DK EE ES FI FR GB GR HR HU IE IS IT LI LT LU LV MC MT NL NO PL PT RO SE SI SK TR**

(30) Priorität: **16.11.2007 DE 102007054744**

(43) Veröffentlichungstag der Anmeldung:
**20.05.2009 Patentblatt 2009/21**

(73) Patentinhaber: **Universitätsklinikum Freiburg**
**78106 Freiburg (DE)**

(72) Erfinder:
- **Hennig, Jürgen**
  **79100 Freiburg (DE)**
- **Zaitsev, Maxim**
  **79117 Freiburg (DE)**
- **Welz, Anna**
  **79194 Gundelfingen (DE)**
- **Schultz, Gerrit**
  **79110 Freiburg (DE)**

(74) Vertreter: **Kohler Schmid Möbus Patentanwälte**
**Partnerschaftsgesellschaft mbB**
**Ruppmannstraße 27**
**70565 Stuttgart (DE)**

(56) Entgegenhaltungen:
**DE-A1-102005 051 021    GB-A- 2 034 123 US-A1- 2005 110 492**

- **JUERGEN HENNIG ET AL: "Parallel imaging in non-bijective, curvilinear magnetic field gradients: a concept study" MAGNETIC RESONANCE MATERIALS IN PHYSICS, BIOLOGY AND MEDICINE, CHAPMAN AND HALL, LONDON, GB, Bd. 21, Nr. 1-2, 26. Februar 2008 (2008-02-26), Seiten 5-14, XP019596833 ISSN: 1352-8661**
- **CHO, ZH.; YI, JH.: "A Novel Type of Surface Gradient Coil" J. MAGN. RESON., Bd. 94, 1991, Seiten 471-485, XP002615058**
- **SCHULTZ G ET AL: "Generalized two-dimensional orthogonal spatial encoding fields" PROCEEDINGS OF THE INTERNATIONAL SOCIETY FOR MAGNETIC RESONANCE IN MEDICINE, 16TH SCIENTIFIC MEETING AND EXHIBITION, TORONTO, CANADA, 3-9 MAY 2008, 19. April 2008 (2008-04-19), Seite 2992, XP002615059**

EP 2 060 927 B1

**Beschreibung**

Die Erfindung betrifft ein Verfahren der bildgebenden Magnetresonanz (NMR), wobei mit Hilfe eines Gradientensystems ein räumlich und zeitlich veränderliches Magnetfeld $B_{grad}$ erzeugt wird zur mindestens zweidimensionalen Ortscodierung von NMR-Messsignalen in einem abzubildenden Bereich einer Messprobe, wobei das Magnetfeld $B_{grad}$ während eines einzelnen Messzyklus vom Anregen bis zum Auslesen der NMR-Messignale in wenigstens zwei Ausprägungen $B_{grad}^1$ und $B_{grad}^2$ im abzubildenden Bereich der Messprobe eingesetzt wird, wobei die erste Ausprägung $B_{grad}^1$ im Wesentlichen ns-polig ausgebildet ist, mit ns eine gerade Zahl > 2 und ns im Wesentlichen sektorförmige Teilbereiche aufweist, in denen jeweils lokal in einer Richtung ein monotoner Verlauf des Magnetfelds $B_{grad}$ vorliegt, wobei die Aufnahme der Messsignale der Messprobe mittels wenigstens ns Empfangsspulen erfolgt, welche eine unterschiedliche Sensitivität über die ns Teilbereiche des abzubildenden Bereichs aufweisen.

Ein solches Verfahren ist aus der DE 10 2005 051 021 A1 bekannt geworden.

Kernspinresonanz(=NMR)-Tomographie, auch genannt bildgebende Magnetresonanz, ist ein leistungsfähiges Verfahren zur Analyse der inneren Struktur von ausgedehnten Proben. Die bildgebende NMR wird insbesondere in der Medizin eingesetzt, um einen dreidimensionalen Einblick in das Innere eines menschlichen Körpers zu nehmen. Die bildgebende NMR kommt vorteilhafter Weise ohne ionisierende Strahlung (wie Röntgenstrahlung) aus und ist nicht-invasiv.

Im Rahmen von NMR-Verfahren wird eine Probe einem starken statischen Magnetfeld ausgesetzt, und Hochfrequenz(=HF)-Pulse werden in die Probe eingestrahlt. Die HF-Reaktion der Probe wird vermessen und ausgewertet. Um im Rahmen der NMR-Tomographie ortsaufgelöste Informationen zu erhalten, muss die NMR-Messung mit einer sogenannten Ortskodierung erfolgen. Zur Ortskodierung werden räumlich und ggf. auch zeitlich veränderliche Magnetfelder eingesetzt (auch "Gradientenfelder" genannt). Die kodierenden Magnetfelder werden dem starken statischen Magnetfeld $B_0$ zeitweise überlagert, der durch die räumliche Änderung der Gradientenfelder bedingte Gradient dB/dz bewirkt eine Ortskodierung, wobei die z-Richtung der Richtung des statischen Feldes entspricht. Im einfachsten Fall wird ein über den abzubildenden Bereich der Probe mit dem Ort monoton (und typischerweise auch linear) veränderliches Magnetfeld zur Kodierung eingesetzt. Es ergibt sich dann eine eindeutige Zuordnung der Larmorfrequenz zum Ort innerhalb des abzubildenden Bereichs.

Das Auflösungsvermögen der bildgebenden NMR hängt stark von der Stärke der Gradienten der kodierenden Magnetfelder ab. Je steiler der Gradient, desto besser die Ortsauflösung der tomographischen Messung.

Wird ein steiler Gradient über einen größeren abzubildenden Bereich einer Probe eingesetzt, so ergeben sich über die Probe erhebliche absolute Magnetfelddifferenzen. Wird dann noch der Gradient schnell geschaltet, wie bei neueren bildgebenden NMR-Verfahren üblich, so treten durch Lorenzkräfte starke mechanische Beanspruchungen (insbesondere Schwingungen) im Tomographen auf, die mit erheblichen Lärmbelastungen (100 dB und mehr) verbunden sind. Zudem kann es zu neurologischen Stimulationen bei Patienten kommen, die einer NMR-Tomographie unterzogen werden.

Um große Magnetfelddifferenzen im abzubildenden Bereich zu vermeiden, wurde vorgeschlagen, den abzubildenden Bereich in Teilbereiche zu unterteilen, in denen jeweils lokal ein monoton verlaufendes kodierendes Magnetfeld herrscht, jedoch die absoluten Magnetfeldbeträge in den verschiedenen Teilbereichen sich wiederholen, vgl. beispielsweise DE 2005 051 021 A1. Innerhalb der Teilbereiche kann dann das kodierende Magnetfeld jeweils einen steilen Gradienten aufweisen, und die absolute Magnetfelddifferenz über den gesamten abzubildenden Bereich ist nur in etwa so groß wie die absolute Magnetfelddifferenz in einem der Teilbereiche. Ein solches kodierendes Magnetfeld wird auch nicht-bijektiv räumlich veränderliches Magnetfeld (NBSEM, ambivalent/non-bijective spacially encoding magnetic field) genannt. Mit einem NBSEM ist die Zuordnung zwischen Magnetfeldstärke und Ort über den abzubildenden Bereich aber nicht mehr eindeutig. Um dennoch eine eindeutige räumliche Zuordnung im abzubildenden Bereich zu erreichen, werden Messspulen mit in den Teilbereichen unterschiedlicher Sensitivität eingesetzt.

Im Rahmen der medizinischen NMR wird üblicherweise das NMR-Signal aus einer Probe in einer Folge von zweidimensional aufgelösten, aufeinander folgenden Schichten vermessen und dargestellt. Zur zweidimensional ortsaufgelösten Vermessung einer einzelnen Schicht ist es bekannt, während eines Messzyklus vom Anregen bis zum Auslesen der NMR-Messsignale entsprechend zwei verschiedene Ausprägungen von kodierendem Magnetfeld einzusetzen.

Die DE 10 2005 051 021 A1, insbesondere Fig. 11 a, 11 b mit zugehöriger Beschreibung, schlägt als die beiden Ausprägungen des kodierenden Magnetfelds in einem Messzyklus einen radialen Feldgradienten sowie eine mehrpolige Feldanordnung jeweils als NBSEMs vor.

Nachteilig an diesem Stand der Technik ist es jedoch, dass bei einer zweidimensionalen Tomographieaufnahme, die mit diesen beiden Ausprägungen des kodierenden Magnetfelds vermessen wird, sich speichenförmige Bereiche mit schlechter Ortskodierung ausbilden. Die DE 10 2005 051 021 A1 empfiehlt als Maßnahme zum Erhalt einer vollständigen Ortskodierung, zwei Tomographieaufnahmen des identischen abzubildenden Bereichs nacheinander zu erstellen, wobei die mehrpolige Feldanordnung von der ersten zur zweiten Tomographieaufnahme um einen halben Polabstandswinkel gedreht wird. Als andere Ausprägung in jeder der beiden Tomographieaufnahmen dient jeweils ein radialer Feldgradient. Da die schlecht aufgelösten speichenförmgien Bereiche beider Aufnahmen gegeneinander versetzt sind, wird in der Kombination beider Tomographieaufnahmen für den gesamten abzubildenden Bereich eine akzeptable Ortsauflösung erhalten. Da bei diesem Vorgehen jedoch zwei aufeinander folgende Tomographieaufnahmen erforderlich sind, verdoppelt sich dadurch die Messzeit eines abzubildenden Bereichs.

### Aufgabe der Erfindung

Der Erfindung liegt daher die Aufgabe zugrunde, ein bildgebendes NMR-Verfahren zur Verfügung zu stellen, bei dem unter der Nutzung der Vorteile von NBSEM schneller eine gut aufgelöste Abbildung des abzubildenden Bereichs erhalten wird.

### Kurze Beschreibung der Erfindung

Diese Aufgabe wird gelöst durch ein Verfahren der bildgebenden NMR, das dadurch gekennzeichnet ist, dass die zweite Ausprägung $B_{grad}^2$ mit Ausnahme der nachfolgend definierten Verdrehung identisch zur ersten Ausprägung $B_{grad}^1$ ausgebildet ist, wobei die zweite Ausprägung $B_{grad}^2$ gegenüber der ersten Ausprägung $B_{grad}^1$ um einen Winkel $\Delta\varphi$, mit $\Delta\varphi = \dfrac{360°}{2 \cdot ns}$, verdreht ist.

Der Erfindung beruht auf der Nutzung von zwei speziell zueinander orientierten Ausprägungen $B_{grad}^1$ und $B_{grad}^2$ eines kodierenden Magnetfelds innerhalb eines Messzyklus, bei denen im gesamten abzubildenden Bereich mit guter Genauigkeit gilt, dass die jeweiligen zugehörigen Feldgradienten dB/dz senkrecht aufeinander stehen. Mit anderen Worten, die jeweiligen Linien gleicher Feldstärke (Höhenlinien) der beiden Ausprägungen stehen senkrecht aufeinander. Nur in den Bereichen, in denen die Feldgradienten der beiden Ausprägungen orthogonal zueinander stehen, stellt sich eine gute und isotrope Ortsauflösung der Tomographieaufnahme ein. Eine solche Orthogonalität ist in guter Näherung bei zwei identischen, aber gegeneinander um einen halben Polabstandwinkel (Polabstandwinkel =360°/ns, mit ns: Anzahl der Pole) gegeneinander gedrehten Multipolfeldern gegeben, wie im Rahmen der Erfindung festgestellt wurde.

Man beachte, dass die beiden erfindungsgemäßen Ausprägungen des kodierenden Magnetfelds im Wesentlichen konzentrisch ausgerichtet sind. Die im Wesentlichen ns-polig ausgebildeten Ausprägungen haben näherungsweise eine Zähligkeits-Symmetrie von ns/2, d.h. durch eine Rotation um ein ganzzahliges Vielfaches von 360°/(ns/2) wird die Ausprägung näherungsweise in sich selbst überführt.

Im Stand der Technik nach DE 10 2005 051 021 A1 liegt eine Orthogonalität der beiden Feldgradienten der beiden Ausprägungen des kodierenden Magnetfelds (radialer Feldgradient und mehrpolige Feldanordnung) nur in den Winkelbereichen zwischen den Polen der mehrpoligen Feldanordnung vor; in den Winkelbereichen auf den Polen (d.h. in den Bereichen der Feldstärkemaxima und Feldstärkeminima der mehrpoligen Feldanordnung) sind die Linien gleicher Feldstärke beider Ausprägungen näherungsweise parallel ausgerichtet (nämlich näherungsweise in Umfangsrichtung). Entsprechend treten in den Winkelbereichen auf den Polen streifenförmige Bereiche schlechter Ortsauflösung auf, die über eine zweite Tomographieaufnahme (d.h. ein zweiter Messzyklus) erfasst werden müssen.

Mit der vorliegenden Erfindung wird eine Abbildung des im Wesentlichen gesamten abzubildenden Bereichs innerhalb eines Messzyklus ermöglicht. Es treten insbesondere keine Regionen im abzubildenden Bereich auf, in denen die Höhenlinien der beiden erfindungsgemäßen Ausprägungen des kodierenden Magnetfelds parallel ausgerichtet wären (und damit die Probe lokal schlecht ortsaufgelöst wäre). Im Vergleich zum Stand der Technik erlaubt die vorliegende Erfindung somit einen Verzicht auf eine zweite Tomographieaufnahme (bzw. einen Verzicht auf einen zweiten Messzyklus) bezüglich desselben abzubildenden Bereichs einer Messprobe (etwa derselben Schicht im Untersuchungsobjekt). Mit dem erfindungsgemäßen Verfahren können somit Tomographieabbildungen guter Auflösung besonders schnell erhalten werden.

### Bevorzugte Varianten der Erfindung

Besonders bevorzugt ist eine Variante des erfindungsgemäßen Verfahrens, bei der im Messzyklus die erste Ausprägung $B_{grad}^1$ als Phasenkodiergradient während der Anregung und die zweite Ausprägung $B_{grad}^2$ als Lesegradient während des Auslesens eingesetzt wird. Auf diese Weise kann eine zweidimensionale Ortskodierung mittels den beiden erfindungsgemäßen Ausprägungen sehr einfach erfolgen.

In den Rahmen der vorliegenden Erfindung fällt auch eine Verwendung einer NMR-Tomographieapparatur, umfassend

- ein Gradientensystem geeignet zur Erzeugung eines zeitlich und räumlich veränderlichen Magnetfelds $B_{grad}$,
- wenigstens ns Messpulen, zur Durchführung eines oben angegebenen erfindungsgemäßen Verfahrens. Das Gradientensystem ist dabei zur Erzeugung der beiden Ausprägungen des kodierenden Magnetfelds geeignet. Die beiden NBSEM-Ausprägungen gestatten hohe Gradientenstärken und damit hohe Ortsauflösungen. Mit den wenigstens ns Messpulen wird die Un-Eindeutigkeit der Ortszuordnung der NBSEM-Ausprägungen aufgehoben. Ein Messzyklus genügt, um einen abzubildenden Bereich vollständig ortsaufgelöst abzubilden. Somit sind insgesamt hohe Ortsauflösungen über große, geschlossene Bereiche (d.h. den gesamten abzubildenden Bereich des jeweiligen Messzyklus) bei kurzer Messzeit im in dieser Verwendung möglich.

Besonders bevorzugt ist eine Verwendungsvariante, die dadurch gekennzeichnet ist,
dass die NMR-Tomographieapparatur ein Gradientensystem mit 2*ns Gradientenspulen umfasst, die ringförmig, insbesondere kreisringförmig, und gleichmäßig zylindrisch verteilt angeordnet sind,
dass die Gradientenspulen zur Erzeugung der ersten Ausprägung $B_{grad}^1$ mit einem ersten Polaritätsschema (++-++-), bei dem jeweils zwei benachbarte Spulen die gleiche Polarität aufweisen, betrieben werden,
und dass die Gradientenspulen zur Erzeugung der zweiten Ausprägung $B_{grad}^2$ mit einem zweiten Polaritätsschema (+--++--+), das gegenüber dem ersten Polaritätsschema um eine Spulenposition verschoben ist, betrieben werden. Das Gradientensystem umfasst die 2*ns Gradientenspulen typischerweise in einer ebenen, ringförmigen Anordnung, wobei die Gradientenspulen zu einem gemeinsamen Zentrum ausgerichtet sind. Grundsätzlich kann das Gradientensystem einheitlich oder auch aus zwei Subgradientensystemen aufgebaut sein. Der einfachste Aufbau der NMR-Tomographieapparatur ist dabei eine ebene, 2*ns-eckige Anordnung der Gradientenspulen, die den abzubildenden Bereich der Probe einschließt, wobei die Gradientenspulen wie oben angegeben betrieben werden.

Eine bevorzugte Verwendungsvariante sieht vor, dass das Gradientensystem zwei Subgradientensysteme umfasst, die jeweils ns Gradientenspulen umfassen, wobei die ns Gradientenspulen jeweils auf einem Ring, insbesondere Kreisring, gleichmäßig zylindrisch verteilt angeordnet sind, wobei die Subgradientensysteme ineinander geschachtelt angeordnet sind und die Gradientenspulen der Subgradientensysteme alternieren. Die beiden Polaritätsschemata für die beiden Ausprägungen des kodierenden Magnetfelds können dann leicht durch die Ansteuerung der beiden Subgradientensysteme als ganzes eingestellt werden. Die Größe (insbesondere der Durchmesser der typischerweise kreisringförmigen, ebenen Ringe) der beiden Subgradientensysteme ist bevorzugt identisch; aus Platzgründen kann es aber erforderlich sein, eines der Subgradientensysteme etwas kleiner zu bauen (etwa bezüglich des Ringdurchmessers) als das andere.

Bei einer Weiterentwicklung dieser Verwendungsvariante sind die Ringe der Subgradientensysteme zusätzlich gegenüber der Richtung eines statischen Hauptmagnetfelds $B_0$ gegeneinander verkippt. Durch die verkippten Ringebenen lässt sich eine Anpassung an die Geometrie der Probe, d.h. des Untersuchungsobjekts (etwa an die kugelähnliche Form eines menschlichen Kopfes) erreichen.

Eine andere vorteilhafte Weiterentwicklung sieht vor, dass die Gradientenspulen der beiden Subgradientensysteme jeweils zu einem Stromkreis zusammengeschlossen sind, in welchem der Strom in alternierender Richtung fließt, und dass für jeden der zwei Stromkreise eine eigene Spannungsquelle eingesetzt wird. Dies vereinfacht die Ansteuerung der Gradientenspulen.

Eine andere bevorzugte Verwendungsvariante ist dadurch gekennzeichnet, dass für jede Gradientenspule eine eigene Spannungsquelle vorgesehen ist, oder dass für Subsets von Gradientenspulen jeweils eine eigene Spannungsquelle vorgesehen ist. In diesem Fall können durch Änderung bzw. Anpassung der Stromstärken in den einzelnen Gradientenspulen die Feldprofile so verändert werden, dass sie an das Untersuchungsobjekt angepasst sind. Bevorzugt ist dabei auch eine Verwendungsvariante, bei der die ringförmig angeordneten Gradientenspulen oval angeordnet sind. Dadurch können die kodierenden Magnetfelder an die Form des Untersuchungsobjekts, insbesondere die Form eines menschlichen Kopfes, angepasst werden.

Bei einer anderen bevorzugten Verwendungsvariante sind als Lesespulen ns zylinderförmige Spulen vorgesehen, die jeweils einzelne Objekte umschließen. Diese Anordnung ist besonders für die Reihenuntersuchung von Mäusen und Ratten geeignet. Die Probe ist hierbei mehrteilig.

Alternativ sieht eine andere Verwendungsvariante vor, dass ns Lesespulen in einer inside-out Anordnung vorgesehen sind. Die ns Lesespulen sind dabei zentrisch bezüglich des Untersuchungsvolumens angeordnet. Auch hiermit können gut Reihenuntersuchungen an Mäusen und Ratten erfolgen.

Weitere Vorteile der Erfindung ergeben sich aus der Beschreibung und der Zeichnung.

Die gezeigten und beschriebenen Ausführungsformen sind nicht als abschließende Aufzählung zu verstehen, sondern haben vielmehr beispielhaften Charakter für die Schilderung der Erfindung.

Detaillierte Beschreibung der Erfindung und Zeichnung

Die Erfindung ist in der Zeichnung dargestellt und wird anhand von Ausführungsbeispielen näher erläutert. Es zeigen:

Fig. 1      ein oktagonales Gradientensystem für Erzeugung eines 8-poligen Magnetfelds oder zwei Ausprägungen eines 4-poligen Magnetfelds für das erfindungsgemäße Verfahren;

Fig. 2a      ein Höhenliniendiagramm eines 8-poligen Magnetfelds;

Fig. 2b      ein Höhenliniendiagramm eines 8-poligen Magnetfelds, rotiert um einen halben Polabstandswinkel (=22,5°) relativ zum Höhenliniendiagramm von Fig. 2a;

Fig. 3      die räumliche Verteilung der Winkel der lokalen Magnetfeldgradienten der Magnetfelder von Fig. 2a und Fig. 2b;

Fig. 4a    ein numerisch erzeugtes Testobjekt zur Demonstration der Abbildungseigenschaften des erfindungsgemäßen Verfahrens;

Fig. 4b    eine Abbildung des Testobjekts von Fig. 4a bei Anwendung eines kodierenden Magnetfelds mit den beiden Ausprägungen radialer Feldgradient und 8-poliges Magnetfeld nach dem Stand der Technik;

Fig. 4c    eine Abbildung des Testobjekts von Fig. 4a bei Anwendung eines kodierenden Magnetfelds mit den beiden Ausprägungen 8-poliges Magnetfeld und gleiches, um 22,5° gedrehtes 8-poliges Magnetfeld gemäß der Erfindung;

Fig. 5    schematische Illustration zur erfindungsgemäßen Erzeugung von zwei 4-poligen Magnetfeld-Ausprägungen mit Verdrehwinkel 45°, mittels zweier Sub-Gradientensysteme;

Fig. 6a    eine schematische Darstellung einer NMR-Tomographie-Apparatur zur erfindungsgemäßen Verwendung mit acht Messspulen, in die jeweils ein Objekt eingeschlossen ist;

Fig. 6b    schematische Darstellung einer NMR-Tomographie-Apparatur zur erfindungsgemäßen Verwendung mit acht Messspulen in inside-out-Anordnung, wobei vor jeder Messspule ein Objekt angeordnet ist.

*Einführung*

Die vorliegende Erfindung betrifft eine Weiterentwicklung von NMR-Tomographieverfahren bzw. Anordnungen, die unter dem Begriff "PatLoc" aus der DE 10 2005 051 021 A1 bekannt geworden sind, und insbesondere die Nutzung von mulitpoligen Kodierungsfeldern in Pseudo-Bessel-Anordnung.

Die vorliegende Erfindung nutzt zur Vermessung von Proben (Untersuchungsobjekten, Messobjekten) in einem abzubildenden Bereich nichtbijektive räumlich kodierende Magnetfelder (=NBSEMs, ambivalent/nonbijective spacially encoding magnetic fields). Nur in Teilbereichen des abzubildenden Bereichs sind jeweils eindeutig kodierende Magnetfelder vorhanden; die Teilbereiche werden typischerweise durch lokale Extrema des Magnetfelds bzw. Hyperflächen, die durch diese lokalen Extrema definiert sind, voneinander abgegrenzt. Um eine Zuordnung von Messsignalen zu Orten verschiedener Teilbereiche zu ermöglichen, werden räumlich selektiv empfindliche Messpulen eingesetzt, und mit Verfahren der parallelen Rekonstruktion kann dann eine vollständige Tomographieaufnahme aus den Signalen der Messpulen erhalten werden. Im einfachsten Fall ist für jeden Teilbereich des Untersuchungsvolumens eine eigene, nur über diesen Teilbereich empfindliche Messspule (Empfangsspule) vorgesehen.

In der DE 10 2005 051 021 A1 wurde gezeigt, dass sich unter Kombination des in der dortigen Figur 11a gezeigten radialen Feldes (hier genannt $SEM_R$) mit einem in der dortigen Figur 11 b gezeigten multipoligen Feldes (hier genannt $SEM_C$) in einem Messzyklus eine zweidimensionale Ortskodierung durchführen lässt. Die innerhalb eines Messzyklus (von Anregung bis zur Aufnahme der Messsignale, typischerweise entsprechend der Vermessung einer einzelnen Schicht eines Messobjekts) angewandten Formen von kodierenden "Gradientenfeldern" werden hier auch als Ausprägungen des (zweidimensional) kodierenden Magnetfelds bezeichnet. In der DE 10 2005 051 021 A1 wird beschrieben, dass die oben genannte Kombination von NBSEMs, d.h. die Verwendung der beiden Ausprägungen $SEM_R$ und $SEM_C$, nur eine eingeschränkte Abbildung ermöglicht, nämlich mit Einschränkungen an den Orten (genauer streifenförmigen Bereichen) der lokalen Feldumkehr des $SEM_C$. Die Druckschrift schlägt vor, für eine kontinuierliche Abbildung (gleichmäßige Ortskodierung) die Aufnahme zu wiederholen, wobei das $SEM_C$ um einen halben Polabstand rotiert ist (bei einer 8-poligen Anordnung um 22,5°). Ein um einen halben Polabstandwinkel gedrehtes multipoliges Feld wird hier im folgenden als $SEM_{IC}$ bezeichnet. Nachteilig an diesem Vorgehen ist die durch die Wiederholung der Messung verdoppelte Messzeit.

*Erfindungsgemäßes Verfahren*

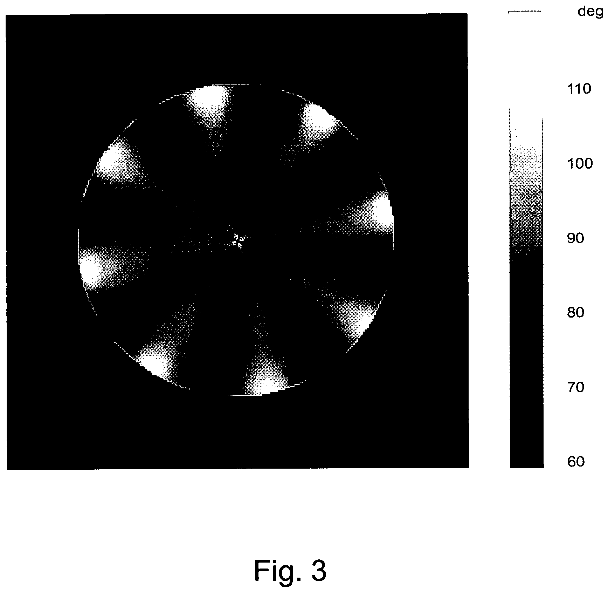

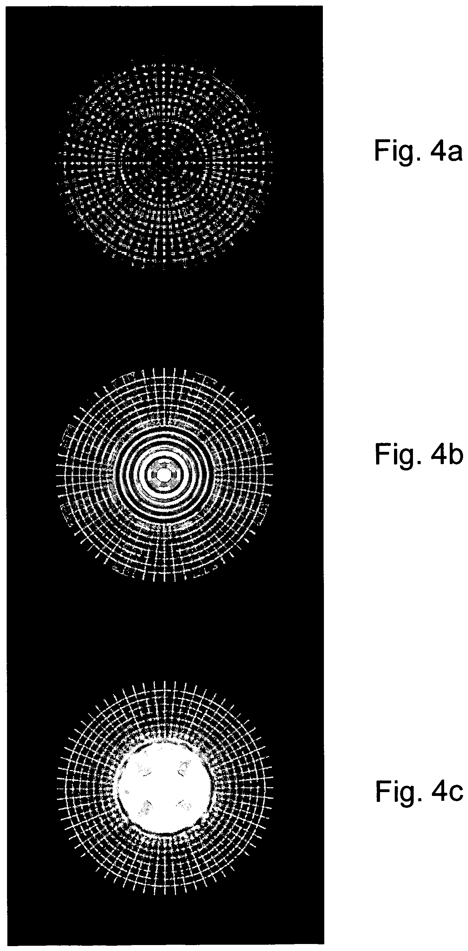

Das erfindungsgemäße Verfahren beruht auf der Beobachtung, dass die von den beiden gegeneinander verdrehten mulitpoligen NBSEMs (also $SEM_C$ und $SEM_{IC}$) erzeugten Magnetfeldgradienten dB/dz über den gesamten Messbereich (nahezu) orthogonal zueinander stehen (vgl. Fig. 3). Ein unter Verwendung dieser beiden NBSEMs ($SEM_C$ und $SEM_{IC}$) als Ausprägungen ($B_{grad}^1$ und $B_{grad}^2$) des kodierenden Magnetfelds ($B_{grad}$) in einem Messzyklus erzeugtes Bild zeigt damit gegenüber dem bekannten Verfahren eine homogenere Abbildung in circumferentieller Richtung (vgl. Fig. 4).

Ein NBSEM (bzw. der zugehörige Gradient) alleine macht eine Ortskodierung entlang einer ersten Richtung, die durch die lokale Richtung des Feldgradienten des NBSEM gegeben ist. Für eine zweidimensionale Ortskodierung braucht es die Informationen entlang der dazu orthogonalen Richtung. Bei Verwendung eines zweiten NBSEM trägt immer nur die (bezüglich des Gradienten des ersten NBSEM) orthogonale Komponente des Gradienten des zweiten NBSEM zur Ortsauflösung bei. Die beiden erfindungsgemäßen Ausprägungen des kodierenden Magnetfelds weisen von vorneherein (weitestgehend) orthogonale Gradienten auf, wodurch eine besonders gute Ortsauflösung erreicht wird.

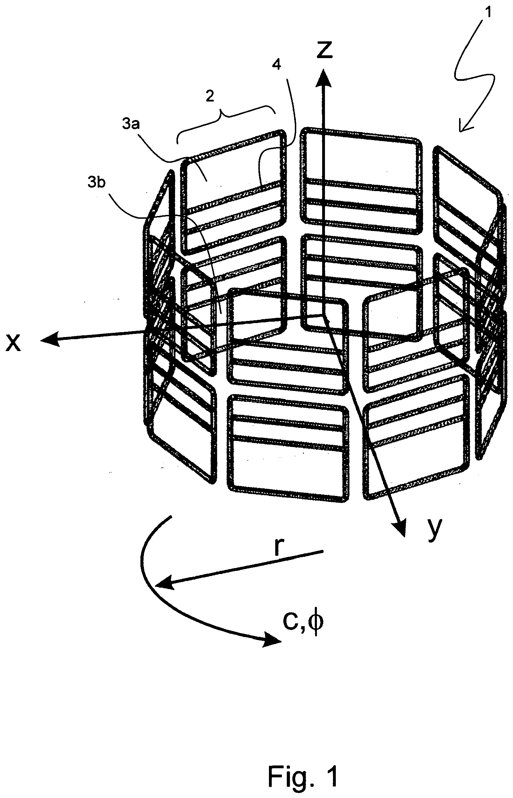

Die **Figur 1** zeigt ein Gradientensystem 1 umfassend acht Gradientenspulen (Einzelspulen) 2, welches zur Erzeugung eines 8-poligen Magnetfelds oder auch zur Erzeugung von zwei gegeneinander um einen halben Polabstandswinkel verdrehten 4-poligen Magnetfeldern geeignet ist, beides zum Einsatz in einem erfindungsgemäßen Verfahren. Jede Einzelspule 2 umfasst hier ein oberes und ein unteres Spulenfenster 3a, 3b. Als Grundeinheit einer solchen Einzelspule 2, welche Felder der gewünschten Geometrie über einen ausgedehnten Bereich in Richtung des statischen Magnetfelds (Hauptmagnetfelds) $B_0$ erlaubt, wurde in Fig.1 eine Konfiguration entsprechend einem bekannten flachen Gradientendesign von Cho und Yi gewählt, vgl. Cho, ZH., Yi, JH. (1991) A Novel Type of Surface Gradient Coil, J. Magn. Reson. 94: 471-495. Das Gradientensystem 1 ist eine oktagonale Anordnung von acht flachen "Kopf-an-Kopf" Einzelspulen 2, welche zylindrisch um die Achse des Hauptmagnetfeldes ($B_0$ in z-Richtung) angeordnet sind. x,y bezeichnen die kartesischen Koordinaten senkrecht zum Hauptmagnetfeld, r und $\phi$ sind die entsprechenden Polarkoordinaten, c kennzeichnet den circumferentiellen Vektor in Richtung mit zunehmendem $\phi$. Der Stromfluss in jeder ,Kopf-an-Kopf Einzelspule 2 ist so, dass die Leiter in den jeweils sechs inneren Sprossen 4 gleichsinnig durchflossen werden. Im Inneren des Gradientensystems 1 ist die Probe angeordnet (nicht dargestellt) bzw. liegt der abzubildende Bereich.

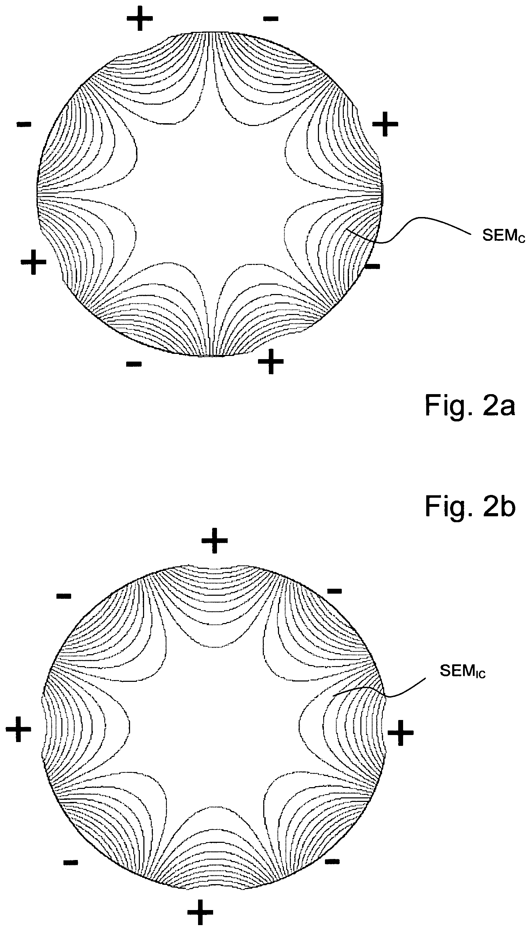

Die **Figur 2a** zeigt ein Höhenliniendiagram des Magnetfelds im zylindrischen Innenraum einer $SEM_C$ genannten Anordnung (bei Erzeugung eines 8-poligen Magnetfelds mit Polschema +-+-+-+-) entsprechend Fig.1. Die Stromrichtung in benachbarten ,Kopf-an-Kopf Einzelspulen ist jeweils umgekehrt, entsprechend wechselt die Polarität der Felder (markiert durch "+" und "-"). Man beachte, dass jeweils in sektorförmigen Teilbereichen (im Winkelbereich von einem "+" bis zum benachbarten "-") ein lokal bijektives Magnetfeld vorliegt. Die **Figur 2b** zeigt ein Höhenliniendiagram des Magnetfelds im zylindrischen Innenraum in einer $SEM_{IC}$ genannten Anordnung, welche durch Rotation um 360°/(2*8) = 22.5° aus $SEM_C$ hervorgeht.

Die **Figur 3** zeigt den lokalen Zwischenwinkel der Gradienten des achtpoligen $SEM_C$ und des achtpoligen $SEM_{IC}$ von Fig. 2a, 2b. Der Zwischenwinkel (bzw. der Winkel zwischen den Höhenlinien) beträgt minimal 70.2°, maximal 109.5°, meist jedoch um 90°.

Die **Figur 4a** zeigt ein numerisch erzeigtes Testobjekt zur Simulation der Abbildungseigenschaften des erfindungsgemäßen Verfahrens. **Figur 4b** zeigt die Abbildung dieses Testobjektes durch Bildgebung mit aus der Literatur bekannten Feldern (d.h. Ausprägungen des kodierenden Magnetfelds) $SEM_R$ und (achtpoligem) $SEM_C$. Es sind acht streifenförmige Bereiche mit schlechter Ortsauflösung erkennbar. **Figur 4c** zeigt die Abbildung des Testobjektes durch Bildgebung mit den erfindungsgemäßen achtpoligen Feldern $SEM_{IC}$ und $SEM_C$; die Abbildung ist in Umfangsrichtung sehr homogen und frei von schlecht aufgelösten Bereichen.

Beim erfindungsgemäßen Verfahren wird auf Grund des nach innen abfallenden Gradientenfeldes die Abbildung gegen das Zentrum zunehmend unscharf, für die 8-polige Anordnung umfasst der Nutzradius etwa die (äußere) Hälfte des begrenzenden Kreises des Gradientensystems, vgl. Fig. 4c. Eine vergleichbare Unschärfe tritt allerdings auch im Stand der Technik auf, vgl. Fig. 4b.

Das erfindungsgemäße Prinzip funktioniert nicht nur für eine 8-polige Anordnung von Spulen, sondern für jede (gerade) Anzahl ns von Spulen in nseckiger Anordnung. Eine NMR-Tomographieapparatur zur Anwendung des erfindungsgemäßen Verfahrens umfasst daher eine ns-eckige Anordnung von kodierfelderzeugenden Spulen mit alternierender Polarität und eine (im Wesentlichen) identische, aber um 180/ns° dagegen gedrehte Anordnung, oder auch eine 2*ns-eckige Anordnung felderzeugender Spulen.

Als Kriterium für die für die Wahl von ns ist anzumerken, dass für kleines ns der Zwischenwinkel (vgl. Fig. 3) zwischen den durch die jeweils komplementären Anordnungen (bzw. deren Gradienten/Höhenlinien) über das abgedeckte Volumen stärker von der Orthogonalität abweicht als für großes ns. Dafür ist für kleines ns der radial nutzbare Bereich weiter zur Mitte hin ausgedehnt, während mit zunehmendem ns das Messfeld zunehmend an den Rand des zylindrischen Abdeckungsvolumens gedrängt wird.

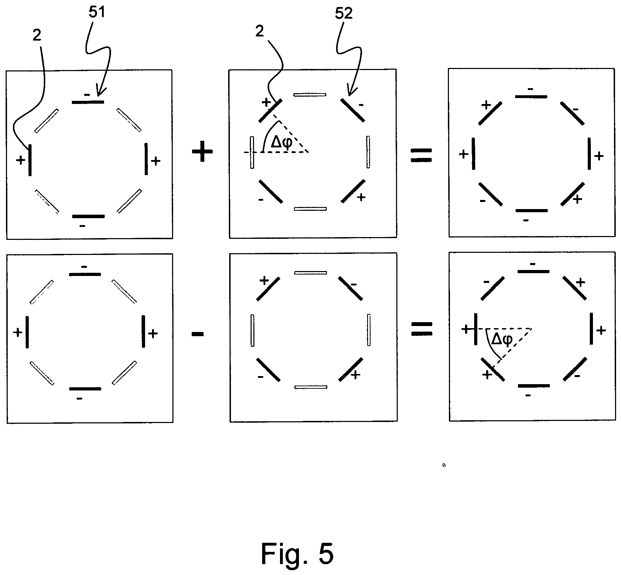

Als eine bevorzugte Art und Weise der Realisierung einer solchen Anordnung werden die ns-poligen Felder durch 2*ns Einzelspulen erzeugt, wobei jeweils ns Einzelspulen in alternierender Anordnung zu einem Stromkreis zusammengeschaltet sind, in welchem wiederum der Strom in alternierender Richtung fließt (Fig. 5). Durch Änderung der Stromrichtung in einer der beiden Anordnungen lassen sich dadurch beide ns-poligen Feldprofile (Ausprägungen) mit ein und derselben Spulenanordnung mit Hilfe von zwei Stromkreisen angeschlossen an zwei Strom/Spannungsquellen erzeugen.

**Figur 5** illustriert das Prinzip der Zusammenlegung von jeweils vier Einzelspulen zu einem Stromkreis mit der durch die Vorzeichen angegebenen Stromrichtung. Durch Addition (oben in Fig. 5) oder Subtraktion (unten in Fig. 5) lassen sich mit dieser Anordnung jeweils 4-polige $SEM_C$ (oben) und zugehörige $SEM_{IC}$ (unten) erzeugen.

Jeweils vier Einzelspulen 2 sind dabei zu einem Subgradientensystem 51, 52 zusammengeschaltet, wobei die Polarität im jeweiligen Subgradientensystem 51, 52 durch entsprechende Verschaltung alterniert (d.h. von Spule zu benachbarter Spule wechselt), wie mit "+" und "-" markiert. Jeweils links in Fig. 5 ist das erste Subgradientensystem 51 dunkel hervorgehoben, jeweils in der Mitte von Fig. 5 ist das zweite Subgradientensystem 52 dunkel hervorgehoben. Die gleichartigen Subgradientensysteme 51, 52 sind konzentrisch ineinander gestellt, wobei sie gegeneinander um einen halben Polabstandswinkel $\Delta\phi$=45° verdreht sind. Durch Addition der Felder der beiden Subgradientensystem 51, 52 lässt sich im Polschema "++--++--" des vierpolige $SEM_C$ erzeugen, vgl. rechts oben in Fig. 5 (Zählung des Polschemas beginnend links in der Mitte); durch Subtraktion (d.h. Stromumkehr im zweiten Subgradientensystem 52) lässt sich im Polschema "+--++--+" das um einen halben Polabstandswinkel $\Delta\phi$=45° verdrehte $SEM_{IC}$ erzeugen, vgl. rechts unten in Fig. 5.

Eine weitere bevorzugte Anordnung für die Messung des menschlichen Kopfes besteht darin, dass die Einzelspulen nicht kreisförmig angeordnet sind, sondern oval, um die Felder geometrisch an eine Kopfform anzupassen. Die Spulenanordnungen (Subgradientensysteme) können dabei zusätzlich gegenüber der Richtung des Hauptmagnetfeldes gegeneinander verkippt werden, um die zylindrische Geometrie einer streng vieleckigen Anordnung mehr in Richtung einer dreidimensional runden, kugelförmigen Geometrie anzupassen.

In einer weiteren bevorzugten Anordnung wird der Strom durch jede der einzelnen Gradientenspulen (oder Subsets davon) durch einen separaten Stromkreis erzeugt. Dies erfordert dann im Grenzfall ns unabhängige Stromkreise und ns Strom/Spannungsquellen. Eine solche Anordnung lässt sich dazu verwenden, durch Änderung der Stromstärke in den einzelnen Spulen die Feldprofile so zu verändern, dass sie an das Untersuchungsobjekt angepasst sind. So lässt sich durch Verstärkung des Stromes in gegenüberliegenden Einzelspulen ein ovales Feldprofil (etwa zur Messung des menschlichen Kopfes) erzeugen.

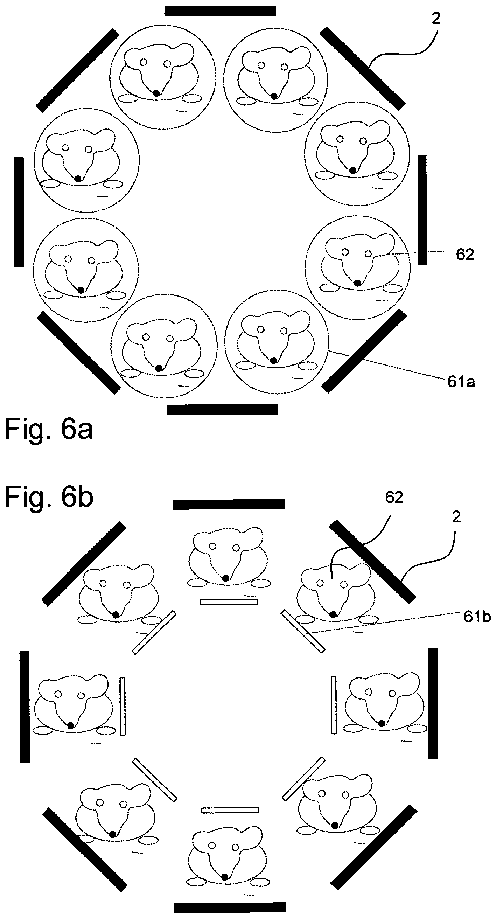

Die Beobachtung des Kernresonanzsignals erfolgt mit Hilfe von nc Empfangsspulen (Messspulen), wobei nc $\geq$ ns gewählt wird, um die ns-fache Ambivalenz der ns-poligen Felder durch Anwendung von Algorithmen der parallelen Bildrekonstruktion in eine eindeutige Ortskodierung überzuführen. Für Messungen an geschlossenen, konkaven Körpern (wie dem menschlichen Kopf) sind die Empfangsspulen bevorzugt in der Peripherie des durch die NBSEMs erzeugten Feldes angeordnet. Es gibt jedoch auch Anwendungen, bei welchen simultan (d.h. in einem Messzyklus) mehrere Objekte untersucht werden sollen, z.B. bei Reihenuntersuchungen an Mäusen und Ratten, vgl. dazu Nieman BJ, Bishop J, Dazai J, Bock NA, Lerch JP, Feintuch A, Chen XJ, Sled JG, Henkelman RM. MR technology for biological studies in mice. NMR Biomed. 2007 May;20(3):291-303. Eine für solche Aufgaben bevorzugte Realisierung des erfindungsgemäßen Verfahrens beruht dabei auf der Verwendung von ns unabhängigen Einzel-Messspulen, welche entweder als zylindrische Spulen die einzelnen Objekte umschließen (Fig.6 oben) oder aber zentrisch angeordnet in einer inside-out Anordnung angeordnet sind (Fig.6 unten).

**Fig. 6a, 6b** illustrieren das Prinzip der Messung von acht Einzelobjekten 62 (z.B. Kleintieren wie Mäusen oder Ratten) in einer oktagonalen Anordnung von Einzelspulen 2 zur Kodierfelderzeugung entsprechend dem erfindungsgemäßen Verfahren. Die Messung der einzelnen Objekte 62 erfolgt jeweils separat (aber im gleichen Messzyklus) durch Messspulen (RF-Spulen, Spulenanordnungen) 61 a, 61 b, welche jedes Einzelobjekt umschließen (61 a in Fig. 6a), oder durch RF-Spulen in ‚inside-out' Anordnung (61 b in Fig. 6b).

**Patentansprüche**

1. Verfahren der bildgebenden Magnetresonanz (NMR),

 wobei mit Hilfe eines Gradientensystems (1) ein räumlich und zeitlich veränderliches Magnetfeld $B_{grad}$ zur mindestens zweidimensionalen Ortscodierung von NMR-Messsignalen in einem abzubildenden Bereich eines Messprobe erzeugt wird,

 wobei das Magnetfeld $B_{grad}$ während eines einzelnen Messzyklus vom Anregen bis zum Auslesen der NMR-Messignale für die Rekonstruktion eines MR-Bilds in wenigstens zwei im Wesentlichen konzentrischen, räumlichen Ausprägungen $B_{grad}^1$ (SEM$_C$) und $B_{grad}^2$ (SEM$_{IC}$) im abzubildenden Bereich der Messprobe zur mindestens zweidimensionalen Ortscodierung eingesetzt wird,

 wobei es sich bei den wenigstens zwei Ausprägungen $B_{grad}^1$ und $B_{grad}^2$ im abzubildenden Bereich jeweils um ein nicht-bijektiv räumlich veränderliches Magnetfeld (NBSEM) handelt,

 wobei die erste Ausprägung $B_{grad}^1$ (SEM$_C$) ns-polig ausgebildet ist, mit ns eine gerade Zahl > 2, und ns im Wesentlichen kreissektorförmige Teilbereiche aufweist, in denen lokal jeweils in einer Richtung ein monotoner Verlauf des Magnetfelds $B_{grad}$ vorliegt,

 wobei die Aufnahme der Messsignale der Messprobe mittels wenigstens ns Empfangsspulen (61a, 61b) erfolgt, welche eine unterschiedliche Sensitivität über die ns Teilbereiche des abzubildenden Bereichs aufweisen, so dass mit Verfahren der parallelen Rekonstruktion das vollständige MR-Bild des abzubildenden Bereichs aus den Messsignalen der ns Empfangsspulen erhalten werden kann,

 **dadurch gekennzeichnet,**

 **dass** die zweite räumliche Ausprägung $B_{grad}^2$ (SEM$_{IC}$) mit Ausnahme der nachfolgend definierten Verdrehung identisch zur ersten räumlichen Ausprägung $B_{grad}^1$ (SEM$_C$) ausgebildet ist, wobei die zweite Ausprägung $B_{grad}^2$ (SEM$_{IC}$) gegenüber der ersten Ausprägung $B_{grad}^1$ (SEM$_C$) um einen Winkel $\Delta\varphi$, mit

$$\Delta\varphi = \frac{360°}{2 \cdot ns} \text{ , verdreht ist.}$$

2. Verfahren nach Anspruch 1, **dadurch gekennzeichnet, dass** im Messzyklus die erste Ausprägung $B_{grad}^1$ (SEM$_C$) als Phasenkodiergradient und die zweite Ausprägung $B_{grad}^2$ (SEM$_{IC}$) als Lesegradient während des Auslesens eingesetzt wird.

3. Verwendung einer NMR-Tomographieapparatur, umfassend

 - ein Gradientensystem (1) geeignet zur Erzeugung eines zeitlich und räumlich veränderlichen Magnetfelds $B_{grad}$,
- wenigstens ns Messpulen (61a, 61b), zur Durchführung eines Verfahrens nach einem der Ansprüche 1 oder 2.

4. Verwendung nach Anspruch 3, **dadurch gekennzeichnet,**
   **dass** die NMR-Tomographieapparatur ein Gradientensystem (1) mit 2*ns Gradientenspulen (2) umfasst, die ringförmig, insbesondere kreisringförmig, und gleichmäßig zylindrisch verteilt angeordnet sind, dass die Gradientenspulen (2) zur Erzeugung der ersten Ausprägung $B_{grad}^1$ ($SEM_C$) mit einem ersten Polaritätsschema (++--++--), bei dem jeweils zwei benachbarte Spulen (2) die gleiche Polarität aufweisen, betrieben werden,
   und **dass** die Gradientenspulen (2) zur Erzeugung der zweiten Ausprägung $B_{grad}^2$ ($SEM_{IC}$) mit einem zweiten Polaritätsschema (+--++--+), das gegenüber dem ersten Polaritätsschema um eine Spulenposition verschoben ist, betrieben werden.

5. Verwendung nach Anspruch 3 oder 4, **dadurch gekennzeichnet, dass** das Gradientensystem (1) zwei Subgradientensysteme (51, 52) umfasst, die jeweils ns Gradientenspulen (2) umfassen, wobei die ns Gradientenspulen (2) jeweils auf einem Ring, insbesondere Kreisring, gleichmäßig zylindrisch verteilt angeordnet sind, wobei die Subgradientensysteme (51, 52) ineinander geschachtelt angeordnet sind und die Gradientenspulen (2) der Subgradientensysteme (51, 52) alternieren.

6. Verwendung nach Anspruch 5, **dadurch gekennzeichnet, dass** die Ringe der Subgradientensysteme (51, 52) zusätzlich gegenüber der Richtung (z) eines statischen Hauptmagnetfelds $B_0$ gegeneinander verkippt sind.

7. Verwendung nach einem der Ansprüche 5 bis 6, **dadurch gekennzeichnet, dass** die Gradientenspulen (2) der beiden Subgradientensysteme (51, 52) jeweils zu einem Stromkreis zusammengeschlossen sind, in welchem der Strom in alternierender Richtung fließt,
   und dass für jeden der zwei Stromkreise eine eigene Spannungsquelle eingesetzt wird.

8. Verwendung nach einem der Ansprüche 4 bis 6, **dadurch gekennzeichnet, dass** für jede Gradientenspule (2) eine eigene Spannungsquelle vorgesehen ist,
   oder dass für Subsets von Gradientenspulen (2) jeweils eine eigene Spannungsquelle vorgesehen ist.

9. Verwendung nach einem der Ansprüche 3 bis 8, **dadurch gekennzeichnet, dass** die ringförmig angeordneten Gradientenspulen (2) oval sind.

10. Verwendung nach einem der Ansprüche 3 bis 9, **dadurch gekennzeichnet, dass** als Messpulen (61a) ns zylinderförmige Lesespulen vorgesehen sind, die jeweils einzelne Objekte (62) umschließen,

11. Verwendung nach einem der Ansprüche 3 bis 10, **dadurch gekennzeichnet, dass** als Messspulen ns Lesespulen (61 b) in einer inside-out Anordnung vorgesehen sind, in welcher einzelne Messobjekte (62) um die Lesespulen (61 b) herum angeordnet sind.

**Claims**

1. Nuclear magnetic resonance (NMR) imaging method
   in which, with the aid of a gradient system (1), there is generated a spatially and temporally variable magnetic field $B_{grad}$ for the at least two-dimensional spatial encoding of NMR measurement signals in a measurement sample region to be imaged,
   where, during a single measurement cycle from excitation to reading of the NMR measurement signals, the magnetic field $B_{grad}$ is employed for the reconstruction of an MR image in at least two substantially concentric, spatial forms $B_{grad}^1$ ($SEM_C$) and $B_{grad}^2$ ($SEM_{IC}$) in the measurement sample region to be imaged for the at least two-dimensional spatial encoding,
   where the at least two forms $B_{grad}^1$ and $B_{grad}^2$ in the region to be imaged are each a non-bijectively spatially variable magnetic field (NBSEM), where the first form $B_{grad}^1$ ($SEM_C$) has ns poles, where ns is an even number > 2, and has ns essentially sectorial sub-regions, in each of which the magnetic field $B_{grad}$ is locally monotonic in one direction,
   where the measurement signals from the measurement sample are recorded by means of at least ns receiver coils (61 a, 61 b) which have different sensitivity over the ns sub-regions of the region to be imaged such that by means of parallel reconstruction methods, the complete MR image of the region to be imaged can be obtained from the measurement signals of the ns receiver coils,
   **characterized in that**
   the second spatial form $B_{grad}^2$ ($SEM_C$) is identical to the first spatial form $B_{grad}^1$ ($SEM_C$) except for the following defined rotation, with the second form $B_{grad}^2$ ($SEM_{IC}$) being rotated by an angle $\Delta\varphi$, where

   $$\Delta\varphi = \frac{360°}{2 \cdot ns},$$ relative to the first form $B_{grad}^1$
   ($SEM_C$).

**2.** Method according to Claim 1, **characterized in that**, in the measurement cycle, the first form $B_{grad}^1$ ($SEM_C$) is employed as phase encoding gradient and the second form $B_{grad}^2$ ($SEM_{IC}$) is employed as reading gradient during reading.

**3.** Use of an NMR tomography apparatus comprising

- a gradient system (1) suitable for the generation of a temporally and spatially variable magnetic field $B_{grad}$,
- at least ns measurement coils (61 a, 61 b),

for performing a method according to one of Claims 1 or 2.

**4.** Use according to Claim 3, **characterized in that** the NMR tomography apparatus comprises a gradient system (1) having 2*ns gradient coils (2) which are arranged in a ring-shape, in particular in a circular ring-shape, and in a uniform cylindrical distribution, **in that** the gradient coils (2) for generation of the first form $B_{grad}^1$ ($SEM_C$) are operated with a first polarity scheme (++--++--), in which in each case two adjacent coils (2) have the same polarity, and **in that** the gradient coils (2) for generation of the second form $B_{grad}^2$ ($SEM_{IC}$) are operated with a second polarity scheme (+--++--+), which is shifted by one coil position relative to the first polarity scheme.

**5.** Use according to Claim 3 or 4, **characterized in that** the gradient system (1) comprises two sub-gradient systems (51, 52), each of which comprises ns gradient coils (2), where the ns gradient coils (2) are in each case arranged on a ring, in particular a circular ring, in a uniform cylindrical distribution, where the sub-gradient systems (51, 52) are arranged nested in one another, and the gradient coils (2) of the sub-gradient systems (51, 52) alternate.

**6.** Use according to Claim 5, **characterized in that** the rings of the sub-gradient systems (51, 52) are additionally tilted with respect to one another with respect to the direction (z) of a static main magnetic field $B_0$.

**7.** Use according to one of Claims 5 and 6, **characterized in that** the gradient coils (2) of the two sub-gradient systems (51, 52) are in each case connected together to form a current circuit, in which the current flows in alternating direction, and **in that** each of the two current circuits is provided with its own voltage source.

**8.** Use according to one of Claims 4 to 6, **characterized in that** each gradient coil (2) is provided with its own voltage source, or **in that** subsets of gradient coils (2) are each provided with their own voltage source.

**9.** Use according to one of Claims 3 to 8, **characterized in that** the gradient coils (2) arranged in a ring shape have an oval shape.

**10.** Use according to one of Claims 3 to 9, **characterized in that** as measurement coils, ns cylindrical reading coils are provided, each of which surrounds an individual object (62).

**11.** Use according to one of Claims 3 to 10, **characterized in that** as measurement coils, ns reading coils (61 b) are provided in an inside-out arrangement, in which individual measurement objects (62) are arranged around the reading coils (61 b).

**Revendications**

**1.** Procédé d'imagerie par résonance magnétique (RMN),
selon lequel un champ magnétique $B_{grad}$ variable dans l'espace et dans le temps pour le codage local au moins bidimensionnel de signaux de mesure RMN est produit à l'aide d'un système de gradient (1) dans une zone à imager d'un échantillon à mesurer,
selon lequel le champ magnétique $B_{grad}$ est utilisé pour le codage local au moins bidimensionnel pendant un cycle de mesure individuel allant de l'excitation à la lecture des signaux de mesure RMN pour la reconstruction d'une image RM en au moins deux expressions spatiales sensiblement concentriques $B_{grad}^1$ ($SEM_C$) et $B_{grad}^2$ ($SEM_{IC}$) dans la zone à imager de l'échantillon à mesurer,
lesdites au moins deux expressions $B_{grad}^1$ et $B_{grad}^2$ dans la zone à imager étant chacune un champ magnétique variable dans l'espace de manière non bijective (NBSEM),
la première expression $B_{grad}^1$ ($SEM_C$) étant formée de ns pôles, ns étant un nombre pair > 2, et présentant ns zones partielles sensiblement en forme de secteur dans lesquelles il existe localement, chaque fois dans une direction, une variation monotone du champ magnétique $B_{grad}$,
l'acquisition des signaux de mesure de l'échantillon à mesurer s'effectuant au moyen d'au moins ns bobines de réception (61a, 61b), lesquelles présentent une sensibilité différente sur les ns zones partielles de la zone à imager, de sorte que des procédés de reconstruction parallèle permettent d'obtenir l'image RM complète de la zone à imager à partir des signaux de mesure des ns bobines de réception,
que la deuxième expression $B_{grad}^2$ ($SEM_{IC}$), à l'exception de la rotation définie ci-après, est identique à la première expression spatiale $B_{grad}^1$ ($SEM_C$), la deuxième expression $B_{grad}^2$ ($SEM_{IC}$) étant tournée

d'un angle $\Delta\varphi$, avec $\Delta\varphi = 360°/2 \cdot ns$, par rapport à la première expression $B_{grad}^1$ ($SEM_C$).

2. Procédé selon la revendication 1, **caractérisé en ce que** dans le cycle de mesure, la première expression $B_{grad}^1$ ($SEM_C$) est utilisée comme gradient de codage de phase et la deuxième expression $B_{grad}^2$ ($SEM_{IC}$) comme gradient de lecture pendant la lecture.

3. Utilisation d'un appareil de tomographie RMN, comprenant

   - un système de gradient (1) permettant de générer un champ magnétique $B_{grad}$ variable dans le temps et dans l'espace,
   - au moins ns bobines de mesure (61a, 61b) pour mettre en oeuvre un procédé selon l'une des revendications 1 ou 2.

4. Utilisation selon la revendication 3, **caractérisée en ce**

   **que** l'appareil de tomographie RMN comprend un système de gradient (1) à 2*ns bobines de gradient (2) qui sont réparties en forme d'anneau, en particulier en forme d'anneau de cercle, et régulièrement cylindriquement,

   **que** les bobines de gradient (2) sont utilisées pour produire la première expression $B_{grad}^1$ ($SEM_C$) avec un premier schéma de polarité (++--++--), dans lequel deux bobines voisines (2) présentent chaque fois la même polarité,

   et **que** les bobines de gradient (2) sont utilisées pour produire la deuxième expression $B_{grad}^2$ ($SEM_{IC}$) avec un deuxième schéma de polarité (+--++--+) qui est décalé d'une position de bobine par rapport au premier schéma de polarité.

5. Utilisation selon la revendication 3 ou 4, **caractérisée en ce que** le système de gradient (1) comprend deux sous-systèmes de gradient (51, 52) qui comprennent chacun ns bobines de gradient (2), les ns bobines de gradient (2) étant chaque fois réparties régulièrement cylindriquement sur un anneau, en particulier un anneau de cercle, les sous-systèmes de gradient (51, 52) étant imbriqués l'un dans l'autre et les bobines de gradient (2) des sous-systèmes de gradient (51, 52) alternant.

6. Utilisation selon la revendication 5, **caractérisée en ce que** les anneaux des sous-systèmes de gradient (51, 52) sont en outre inclinés les uns par rapport aux autres par rapport à la direction (z) d'un champ magnétique principal statique $B_0$.

7. Utilisation selon l'une des revendications 5 à 6, **caractérisée en ce que** les bobines de gradient (2) des deux sous-systèmes de gradient (51, 52) sont associées chaque fois en un circuit dans lequel le courant circule en sens alterné, et qu'une source de tension distincte est utilisée pour chacun des deux circuits.

8. Utilisation selon l'une des revendications 4 à 6, **caractérisée en ce qu'**une source de tension distincte est prévue pour chaque bobine de gradient (2), ou qu'une source de tension distincte est prévue chaque fois pour des sous-ensembles de bobines de gradient (2).

9. Utilisation selon l'une des revendications 3 à 8, **caractérisée en ce que** les bobines de gradient (2) disposées en forme d'anneau sont ovales.

10. Utilisation selon l'une des revendications 3 à 9, **caractérisée en ce que** ns bobines de lecture cylindriques, qui entourent chaque fois des objets (62) individuels, sont prévues comme bobines de mesure (61 a).

11. Utilisation selon l'une des revendications 3 à 10, **caractérisée en ce que** ns bobines de lecture (61b) dans une disposition inside-out, dans laquelle des objets à mesurer (62) individuels sont disposés autour des bobines de lecture (61b), sont prévues comme bobines de mesure.

Fig. 1

Fig. 2a

Fig. 2b

Fig. 3

Fig. 4a

Fig. 4b

Fig. 4c

Fig. 5

Fig. 6a

Fig. 6b

**IN DER BESCHREIBUNG AUFGEFÜHRTE DOKUMENTE**

**In der Beschreibung aufgeführte Patentdokumente**

- DE 102005051021 A1

- DE 2005051021 A1

**In der Beschreibung aufgeführte Nicht-Patentliteratur**

- **CHO, ZH. ; YI, JH.** A Novel Type of Surface Gradient Coil. *J. Magn. Reson.,* 1991, vol. 94, 471-495

- **NIEMAN BJ ; BISHOP J ; DAZAI J ; BOCK NA ; LERCH JP ; FEINTUCH A ; CHEN XJ ; SLED JG ; HENKELMAN RM.** MR technology for biological studies in mice. *NMR Biomed.,* Mai 2007, vol. 20 (3), 291-303